# EUROPÄISCHE PATENTANMELDUNG

(11) **EP 1 289 009 A2**
(43) Veröffentlichungstag der Anmeldung: **05.03.2003**
(21) Anmeldenummer: 02018858.7
(22) Anmeldetag: 23.08.2002
(51) Int. Cl.: H01L 23/02

(54) **Mechanische Strukturierung von Abdeckungsmaterialien zur Verwendung in der elektrischen Aufbau- und Verbindungstechnik**

(30) Priorität: 25.08.2001 DE 10141709; 25.08.2001 DE 10141710
(71) Anmelder: Schott Glas, 55122 Mainz (DE)
(72) Erfinder: Bieck, Florian, 55118 Mainz (DE)
(74) Vertreter: Herden, Andreas F.

(57) **Zusammenfassung**

Die Erfindung betrifft die Strukturierung von Abdeckungsmaterialien (1) zum Aufbringen auf ein Trägersubstrat (5) mit wenigstens einem integrierten Bauelement. Die Erfindung betrifft außerdem ein Verfahren und eine Vorrichtung zum Erzeugen einer Struktur in einem Werkstück, insbesondere in einem Siliziumwafer, mittels Ultraschallschwingläppen. Aufgabe der Erfindung ist es vor allem, einen gegenüber dem Stand der Technik neuen und wesentlich verbesserten Weg aufzuzeigen, mit welchem die Strukturierung eines Abdeckungsmaterials (1) bzw. die Montage integrierter Schaltungen, also insbesondere die Gehäusung und Kontaktierung von integrierten Schaltungen, deutlich vereinfacht wird.

Die Erfindung sieht vor, zur Strukturierung eine im wesentlichen ebene Platte derart auszubilden, dass Schlitze (3) im wesentlichen entlang Zerlegungslinien angeordnet sind. Mit dem erfindungsgemäßen Verfahren werden längliche Öffnungen in dem Wafer erzeugt. Mittels des Ultraschallschwingläppens lassen sich extrem schnell und kostengünstig sehr schmale Öffnungen oder Schlitze mit hoher Oberflächengüte auch in spröde Materialien einbringen.

Mittels des Ultraschallschwingläppens lassen sich extrem schnell und kostengünstig auch sehr kleine oder schmale Öffnungen oder Schlitze mit hoher Oberflächengüte auch in spröde Materialien einbringen.

## Beschreibung

Die Erfindung betrifft ein Verfahren zur Strukturierung eines Abdeckungsmaterials zum Aufbringen auf ein Trägersubstrat mit wenigstens einem integrierten Bauelement und ein entsprechend strukturiertes Abdeckungsmaterial. Die Erfindung betrifft des weiteren ein Verfahren und eine Vorrichtung zum Erzeugen einer Struktur in einem Werkstück, insbesondere in einem Siliziumwafer, und zum Erzeugen einer Struktur mittels Läppen im speziellen.Außerdem betrifft die Erfindung ein Verfahren zur Montage von wenigstens einem in einem Trägersubstrat integrierten Bauelement sowie eine entsprechende Vorrichtung mit wenigstens einem auf einem Trägersubstrat integrierten Bauelement.

Zur Miniaturisierung von elektrischen Bauteilen, insbesondere auf Boardebene werden stetig zunehmend in Trägersubstrate integrierte Schaltungen oder Bauelemente eingesetzt. Bei der mechanischen Gehäusung und/oder elektrischen Kontaktierung derartiger integrierter Schaltungen ("Chips"), beispielsweise auch von optischen Schaltungen oder Bauelementen, werden bei den sogenannten "Electronic Packaging" Verfahren Materialien wie beispielsweise Glas oder ein Kunststoff als Kontakt- oder Abdeckmaterial verwendet.

Elektronische Halbleiterchips haben in den letzten Jahrzehnten die Technik in großem Maße bereichert und verändert, wobei die Halbleiterindustrie weltweit zu einem der wichtigsten Industriezweige aufgestiegen ist.

Trotzdem oder vielleicht auch gerade wegen der damit verbundenen Vielfalt existieren im Bereich der Halbleiterchip-Herstellung noch immer eine Vielzahl von technischen Schwierigkeiten, insbesondere im Bereich der mechanischen Bearbeitung der Wafer.

Um die Gehäusung eines Chips bzw. eines integrierten Bauelements noch im Waferverband durchzuführen und mit dem Bauelement verbundene Kontakte auf wenigstens einen äußeren Oberflächenbereich zu führen, so dass das integrierte Bauelement beispielsweise auf Leiterplatten elektrisch verbunden werden kann, sind eine Vielzahl von Verfahren entwickelt und auch teilweise eingesetzt worden.

Häufig stellt sich hierbei das grundlegende Problem, dass die bei der Kontaktierung und/oder zur Abdeckung verwendeten Materialien nur schwer zu strukturieren sind, um beispielsweise hindurch führende Kontaktverbindungen bereitzustellen.

Zum Herstellen von Löchern in dem Kontakt- oder Abdeckungsmaterial werden häufig Techniken wie z.B. Ultraschallschwingläppen eingesetzt, wobei sich in diesem Fall mit konventionellen Verfahren jedoch nur Löcher von ca. 0,5 mm Durchmesser erzeugen lassen und derartige Verfahren herkömmlicher Weise sehr kostenintensiv sind. Daneben sind photostrukturierbare Gläser, wie z.B. "Foturan" verfügbar, mit denen sich über Photolithographie feine Strukturen erzeugen lassen. Nachteilig hierbei ist jedoch, dass diese Gläser herkömmlicherweise nicht zum Ausdehnungskoeffizienten von Silizium, welches üblicherweise als Trägersubstrat für die integrierte Schaltung verwendet wird, passen. Darüber hinaus lässt sich ein solches Glas nur schlecht bearbeiten und benötigt ferner Flusssäure zur Strukturierung. Auch führt ein Einsatz derartiger Gläser folglich zu hohen Kosten.

Das Erzeugen hoch präziser Löcher ist ferner beispielsweise durch Einsatz von Laserstrahlung möglich, wobei ein solches Verfahren aufgrund des seriellen Bearbeitungsprozesses der Löcher und einer äußerst geringen Abtragsrate ökonomisch für eine Massenfertigung nicht vertretbar ist.

Ferner, wie beispielsweise aus dem Dokument WO 99/40624 bekannt, wurde bereits vorgeschlagen, dass sich mehrere elektrische Kontakte jeweils ein Loch teilen, so dass hierdurch die Anzahl der Löcher reduziert und folglich die Strukturgröße erhöht werden kann. Auch hierbei werden jedoch immer noch sehr kleine, und somit schwer herzustellende Löcher benötigt, wobei zusätzlich die Führung mehrerer Kontaktverbindungen durch ein Loch kompliziert ist.

Nach der Bestückung mit Halbleiterelementen wird ein Siliziumwafer zum Beispiel in einzelne zumeist quadratische Chips zerteilt (sogenanntes "Dicing"). Typischerweise wird das Zerteilen mit einer Säge Schnitt für Schnitt mit einem Vorschub von etwa 2 bis 3 mm/min durchgeführt. Daher kann die Dauer des vollständigen Zerteilens eines Wafers in der Größenordnung eines ganzen Tages liegen und verursacht entsprechend hohe Kosten. Ferner können die durch das Sägen erzeugten Schnittkanten unter Umständen von relativ großer Rauhigkeit sein.

Es ist ferner bekannt, den Siliziumwafer sandwichartig zwischen zwei isolierenden Packschichten einzupacken. Die mechanischen Eigenschaften der Packschichten können je nach Material das Zersägen in Chips zusätzlich erschweren und verlangsamen.

Ferner ist es aus der U.S.-Patentschrift US-A-6,022,758 bekannt, die Packschicht mit Schlitzen zu versehen, um derart eingepackte Wafer zu kontaktieren. In der U.S.-Patentschrift US-A-6,022,758 wird zu diesem Zweck vorgeschlagen, die Schlitze in die Packschicht zu schleifen. Das Schleifen kann aber je nach Material der Packschichten ebenfalls langwierig sein und erfordert typischerweise hochpräzise und kostenintensive Schleifwerkzeuge. Hierbei hat sich gezeigt, dass besonders eine großflächige und gleichzeitige präzise Strukturierung insbesondere eines eingepackten Wafers Schwierigkeiten bereitet.

### Aus dem Dokument

US-A-6,022,758 ist auch bekannt, das Kontakt- oder Abdeckungsmaterial nach dem Aufbringen auf das Trägersubstrat mit Gräben, sogenannten "V-Grooves" zu versehen, die üblicherweise bis in das Trägersubstrat hinein reichen, so dass hierüber Kontaktverbindungen zum Außenbereich hergestellt werden können.

Nachteilig hierbei ist insbesondere, dass in Folge der relativen Breite der Schleifscheibe zum Herstellen dieser Gräben im Verhältnis zu den Dimensionen des integrierten Bauelements der Platzbedarf und in Folge die Ausbeute, bezogen auf das Trägersubstrat relativ gering ist. Herkömmlicherweise weisen derartige Gräben eine Breite von 180 bis 300 µm auf. Darüber hinaus ist das Schleifen der Gräben sehr langsam mit ungefähr 2 bis 3 mm pro Minute und erfolgt sequentiell mit sehr teuren "Dicing-Sägen", so dass auch hierdurch die Fertigungskosten in die Höhe getrieben werden.

Eine Aufgabe der Erfindung ist es, einen gegenüber dem Stand der Technik neuen und wesentlich verbesserten Weg aufzuzeigen, mit welchem die Strukturierung eines Abdeckungsmaterials bzw. die Montage integrierter Schaltungen, also insbesondere die Gehäusung und Kontaktierung von integrierten Schaltungen deutlich vereinfacht, eine wesentliche Verringerung der aufgezeigten Probleme des Standes der Technik und eine signifikante Reduzierung der Fertigungskosten erreicht wird.

Zudem ist es eine Aufgabe der vorliegenden Erfindung, ein Verfahren und eine Vorrichtung zur effizienten, schnellen und kostengünstigen mechanischen Bearbeitung von Werkstücken insbesondere von beschichteten oder eingepackten Siliziumwafern zur Verfügung zu stellen.

Eine weitere Aufgabe der Erfindung ist es, ein Verfahren und eine Vorrichtung verfügbar zu machen, mit welchen die Erzeugung verschiedener auch komplexer Strukturen in einem Werkstück, insbesondere in einem beschichteten oder eingepackten Siliziumwafer ermöglicht wird.

Noch eine Aufgabe der Erfindung ist es, ein Verfahren und eine Vorrichtung zum Erzeugen einer Struktur in einem Werkstück zur Verfügung zu stellen, welche die Nachteile bekannter Verfahren bzw. Vorrichtungen vermeiden oder zumindest mindern.

Noch eine weitere Aufgabe der Erfindung ist es, einen Wafer oder einen Halbleiterchip mit verbesserten Eigenschaften, insbesondere mit hoher Oberflächengüte verfügbar zu machen.

Die erfindungsgemäße Lösung ist durch ein Verfahren mit den Merkmalen des Anspruchs 1 bzw. des Anspruchs 27 und durch einen Wafer nach Anspruch 39 sowie durch eine Vorrichtung mit den Merkmalen des Anspruchs 40 bzw. 46 und 52 bzw. 53 gegeben.

Vorteilhafte und/oder bevorzugte Ausführungsformen bzw. Weiterbildungen sind Gegenstand der jeweiligen abhängigen Ansprüche.

Erfindungsgemäß ist somit vorgesehen, zur Strukturierung eines Abdeckungsmaterials oder Trägermaterials zum Aufbringen auf ein Trägersubstrat mit wenigstens einem integrierten Bauelement, eine im wesentlichen ebene Platte derart mit Schlitzen auszubilden, dass Schlitze im aufgebrachten Zustand im wesentlichen entlang für eine Zerlegung des Trägersubstrats in wenigstens einen, wenigstens ein integriertes Bauelement umfassenden Chip entsprechend zuordenbaren Zerlegungslinien angeordnet sind.

Von Vorteil hierbei ist, dass derartige Schlitze in dem Abdeckungsmaterial mit relativ kleinen Toleranzen fertigbar sind. Ferner ist insbesondere bei Einsatz von Sandstrahlung eine derartige Strukturierung in kurzer Zeit durchführbar, so dass die Abtragsrate bei einem derartigen abrasiven Prozeß sehr hoch ist.

Da von der Erfindung ferner vorgesehen ist, nach dem Aufbringen des strukturierten Abdeckungsmaterials an dem Trägersubstrat wenigstens eine durch einen Schlitz hindurch führende Kontaktverbindung zu einer dem wenigstens einen Bauelement zugeordneten Kontaktierungseinrichtung auszubilden, hat für ein in bevorzugter Weise photolithographisch durchzuführendes Ausbilden der Kontaktverbindung, eine durch Sandstrahlen vorgenommene Strukturierung ferner den Vorteil, dass trichterförmige Mündungen erzeugt werden.

Die Erfindung umfasst jedoch ferner Ausführungsformen, bei denen das Ausbilden der Kontaktverbindung mittels eines insbesondere stromlosen Abscheidungsprozesses bzw. mittels einer Schichtabscheidung, insbesondere einem CVD (Chemical Vapour Deposition)-Verfahren oder PVD (Physical Vapour Deposition)-Verfahren durchgeführt wird.

Wird das Trägersubstrat einschließlich des aufgebrachten strukturierten Abdeckungsmaterials in wenigstens einen, wenigstens ein integriertes Bauelement umfassenden Chip zerlegt, so ist durch die Anordnung von Schlitzen entlang der für die Zerlegung dem Trägersubstrat zuordenbaren Zerlegungslinien gleichzeitig das entsprechende Design für ein "Waver Level Packaging" definiert, wobei lediglich zwischen den Schlitzen stehengelassene Stege gesägt werden müssen und sich die Zerlegung dadurch deutlich gegenüber dem Stand der Technik vereinfacht.

Gemäß einer bevorzugten Ausführungsform der Erfindung umfassen die Schlitze im Abdeckungsmaterial hierzu eine Schlitzbreite von ca. 200 µm bis 500 µm und weisen zum Stehenlassen von Stege eine gegenüber den jeweiligen Längen der entsprechenden Zerlegungslinien kürzere Schlitzlängen auf.

Insbesondere, um eine gleichbleibende Qualität bei der Strukturierung des Abdeckungsmaterials zu gewährleisten, ist ferner vorgesehen, zum Ausbilden der Schlitze an dem Abdeckungsmaterial zunächst eine entsprechend vorstrukturierte Maske aufzubringen.

Je nach Anwendungsgebiet bzw. Aufbau und Funktion des wenigstens einen in dem Trägersubstrat integrierten Bauelements, ist vorgesehen, das Abdeckungsmaterial beispielsweise aus einem Kunststoff bereitzustellen, welcher beispielsweise zur Verbesserung der Steifigkeit oder Zuverlässigkeit des montierten Chips mit einer vorgebbaren Flexibilität bereitgestellt ist. Ferner ist vorgesehen, das Abdeckungsmaterial, insbesondere bei Aufbringung auf einen optisch aktiven Oberflächenbereich an dem Trägersubstrat aus Glas oder einem anderen transparenten Material bereitzustellen. Ferner ist vorgesehen, je nach spezifischem Anwendungszweck beschichtetes, also insbesondere frequenzselektives Glas und/oder strukturiertes, also insbesondere als Mikrolinse oder Grating verwendbares Glas als Abdeckungsmaterial einzusetzen.

Eine weitere bevorzugte Art der Strukturierung sieht das Ausbilden der Schlitze mittels einem Ultraschallschwingläppen vor, welches dem Sandstrahlen in Bezug auf die Genauigkeit überlegen ist.

Insbesondere besitzt dabei der Stempel entlang der ersten Dimension einen zumindest abschnittweise gleichbleibenden formgebenden Querschnitt. Besonders bevorzugt ist der Querschnitt zum Werkstück hin verjüngend, insbesondere dreieckig oder trapezförmig oder alternativ rechteckig ausgebildet.

Gemäß einer weiteren bevorzugten Ausführungsform weist der längliche Läppstempel insbesondere regelmäßig abwechselnd materialabtragende Abschnitte, z.B. mit den vorgenannten Querschnittsformen und Ausschnitte oder Aussparungen auf, so dass gleichzeitig eine Mehrzahl von Vertiefungen und/oder Öffnungen in dem Werkstück erzeugbar ist. Mit dieser Ausführungsform werden besonders vorteilhaft gleichzeitig oder in einem Arbeitsschritt mehrere insbesondere linienförmige und/oder fluchtende Öffnungen oder Schlitze erzeugt.

Besonders vorteilhaft bei der Verwendung des erfindungsgemäßen Läppstempels ist es, dass eine Mehrzahl von universellen oder gleichen Läppstempeln, z.B. ohne Aussparungen vorgehalten werden kann und ein universeller Läppstempel kurzfristig vor Ort, z.B. mittels einer Präzisionsschleifmaschine mit den benötigten Aussparungen versehen oder entsprechend abgerichtet werden kann. Somit können kostengünstig insbesondere auch verschiedene längliche und/oder linienförmige Strukturen erzeugt werden.

Das erfindungsgemäße Verfahren hat sich, insbesondere in Kombination mit den vorgenannten Querschnittsformen des Läppstempels als besonders geeignet erwiesen, um Halbleiter- oder Siliziumwafer zu bearbeiten, welche ein- oder beidseitig insbesondere mit einer bzw. zwei Glasscheiben, Glasträgern oder anderen spröden Packschichten beschichtet oder verbunden sind.

Das Aufbringen des Siliziumwafers auf einem Glasträger, z.B. durch Kleben mit Epoxidharz wird typischerweise für die Herstellung von optischen Chips, z.B. von CCDs verwendet. Eine Schwierigkeit, welche durch dieses Verbinden, Beschichten oder Packen insbesondere mit Glasträgern entsteht, ist, dass Kontaktstellen oder sogenannte Bondpads auf dem Wafer abgedeckt werden.

Insbesondere für dieses Anwendungsfeld der eingepackten Wafer bietet die Erfindung eine einfache und zugleich effiziente Lösung zum Freilegen der Kontaktstellen, welche bislang typischerweise aufwendig und langsam freigeschliffen wurden.

Gemäß einer besonders bevorzugten Ausführungsform der Erfindung werden die Kontaktstellen, welche sich auf einer zweiten Oberfläche, die der ersten Oberfläche gegenüberliegt, durch den Siliziumwafer hindurch mittels des Läppens freigelegt. Hierbei kann auch sukzessive zunächst eine Öffnung in eine auf der, der Oberfläche des Wafers mit den Kontaktstellen abgewandten Seite angebrachten Glasscheibe und danach in dem Wafer oder umgekehrt erzeugt werden.

Gemäß einem weiteren Ausfühfungsbeispiel wird eine auf der Oberfläche des Wafers mit den Kontaktstellen angebrachten Glasscheibe mit Öffnungen versehen, so dass keine Durchkontaktierung durch den Wafer notwendig ist.

Für die Freilegung der Kontaktstellen auf dem Wafer werden vorzugsweise Gräben mit einem trapezförmigen oder dreieckigen Querschnitt oder sogenannte V-Gräben oder V-Grooves in den Wafer oder den Glas-Siliziumwafer-Verbund geläppt.

Alternativ zur Strukturierung eines Glas-Siliziumwafer-Verbundes wird vorzugsweise eine Glasscheibe oder ein Glasträger vor der Verbindung mit dem Wafer strukturiert.

Die letztgenannte beispielhafte Ausführungsform des erfindungsgemäßen Verfahrens ist besonders in Verbindung mit einem Verfahren vorteilhaft, das unter dem Titel "Mechanische Strukturierung von Abdeckungsmaterialien zur Verwendung in der elektrischen Aufbau- und Verbindungstechnik" von demselben Anmelder beim Deutschen Patent- und Markenamt eingereicht wurde. Der Inhalt der genannten anderen Anmeldung ist hiermit durch Bezugnahme vollumfänglich zum Gegenstand dieser Offenbarung gemacht.

Die Erfindung umfasst ferner Ausführungsformen, bei denen das Abdeckungsmaterial auf einen vorderseitigen Oberflächenbereich und/oder rückseitigen, also insbesondere bei optischen Bausteinen auf einen optisch aktiven und/oder passiven Oberflächenbereich des Trägersubstrates aufgebracht wird.

Beim vorderseitigen und rückseitigen Aufbringen von Abdeckungsmaterialien müssen hierbei jedoch nicht gleiche Materialien verwendet werden, sondern die beiden Abdeckungsmaterialien sind in vorteilhafter Weise mechanisch aneinander derart angepasst, dass sich die Steifigkeit beider Abdeckungsmaterialien, welche sich insbesondere aus der jeweiligen Dicke, dem E-Modul und den Wärmeausdehnungskoeffizienten ergeben, gegenseitig kompensieren.

Zum Aufbringen des Abdeckungsmaterials auf dem Trägersubstrat wird das Abdeckungsmaterial mit einem Haftmittel vorzugsweise mittels Siebdruck beschichtet, wobei sich in bevorzugter Weiterbildung Epoxidharze, ein Wachs und/oder ein Sol Gel als besonders geeignete Haftmittel erwiesen haben. Alternativ ist vorgesehen eine Haftung durch anodisches Bonden erzielt wird.

Darüber hinaus ist erfindungsgemäß vorgesehen, je nach spezifischer Anwendung bzw. Funktion des abgedeckten, in dem Trägersubstrat integrierten Bauelements, die Schlitze wenigstens teilweise mit einem Füllmaterial aufzufüllen. Je nach weiterer Verwendung umfasst das Füllmaterial hierzu leitfähiges Material zur Herstellung einer Kontaktverbindung und/oder ein isolierendes Füllmaterial. So lässt sich beispielsweise durch Verwendung eines Füllmaterials mit Epoxidharz ein quasi-hermetisches Package herstellen.

Das erfindungsgemäße Verfahren wird bevorzugt auch zum Durchtrennen oder Zerteilen des Wafers oder des Glas-Siliziumwafer-Verbunds in einzelne Chips, dem sogenannten Dicing verwendet. Es ist von Vorteil, dass ein Schnitt entlang des gesamten Wafers gleichzeitig und daher sehr schnell in einem Arbeitsschritt erfolgen kann. Hierfür wird z.B. ein einfach herstellbarer rechteckiger langer Stempel, insbesondere ohne Aussparungen verwendet.

Die Abtraggeschwindigkeit beträgt vorzugsweise etwa 0,1 mm/min bis 5 mm/min, so dass die Erzeugung der erfindungsgemäßen Struktur, insbesondere entlang des gesamten Wafers weniger als 40 min, als 20 min oder als 10 min, besonders bevorzugt weniger als 5 min oder als 1 min in Anspruch nimmt.

Gemäß einer bevorzugten Weiterbildung der Erfindung wird ein Werkzeug mit mehreren Läppstempeln oder ein Läppstempel mit mehreren z.B. parallel verlaufenden materialabtragenden länglichen Abschnitten vorgesehen, so dass insbesondere gleichzeitig mehrere parallele Strukturen oder Schnitte in dem Wafer erzeugt werden. Somit kann sogar gleichzeitig die Bearbeitung oder Strukturierung, z.B. die Zerteilung oder die Versehung mit Gräben des gesamten Wafers vorgenommen werden.

Bevorzugt weist die Struktur, insbesondere die beim Zerteilen entstehenden Schnittkanten und/oder die erzeugten Gräben eine arithmetische Rauheit von kleiner als 10 µm, bevorzugt kleiner als 5 µm, besonders bevorzugt im Bereich von 1 µm bis 2 µm auf.

Vorzugsweise weisen die Struktur, Öffnungen oder Gräben eine Breite quer zur ersten Dimension von kleiner als 2 mm, als 1 mm, als 800 µm, als 500 µm, als 300 µm, als 200 µm oder als 100 µm. Besonders bevorzugt beträgt die Breite zwischen 180 µm und 500 µm, insbesondere zwischen 200 µm und 300 µm. Ferner wird vorzugsweise eine Positioniergenauigkeit für die die Struktur, Öffnungen oder Gräben von kleiner als 50 µm oder kleiner als 20 µm erreicht.

Im Folgenden wird die Erfindung anhand von bevorzugten Ausführungsbeispielen und unter Bezugnahme auf die Figuren näher erläutert, wobei gleiche Bezugszeichen gleiche oder ähnliche Elemente bezeichnen.

### Kurzbeschreibung der Figuren

Es zeigen:
- Fig. 1: eine Draufsicht auf eine erste Ausführungsform eines Siliziumwafers,
- Fig. 2: einen vergrößerten Ausschnitt des Wafers aus Fig. 1 mit zusätzlichen Details,
- Fig. 3: eine schematische Prinzipskizze eines geschlitzten Träger- bzw. Abdeckungsmaterials,
- Fig. 4: eine schematische Ansicht des geschlitzten Materials gemäß Fig. 3, welches mit einem Haftmittel zum Aufbringen auf ein Trägersubstrat beschichtet ist, und
- Fig. 5: eine Teilansicht eines quasi-hermetischen Packages mit einem auf dem rückseitigen Oberflächenbereich eines Trägersubstrats mit optisch aktiven Bauelementen aufgebrachten Abdeckungsmaterial.
- Fig. 6: eine Schnittzeichnung entlang der Schnittlinie A-A in Fig. 2,
- Fig. 7: eine perspektivische Ansicht einer ersten Ausführungsform des erfindungsgemäßen Läppstempels,
- Fig. 8: eine perspektivische Ansicht eines Ausschnitts einer zweiten Ausführungsform eines Siliziumwafers,
- Fig. 9: eine Draufsicht auf einen Ausschnitt einer Glasscheibe zum Aufkleben auf einen Wafer,
- Fig. 10: eine Schnittzeichnung entlang der Schnittlinie B-B in Fig. 9,
- Fig. 11: eine Schnittzeichnung entlang der Schnittlinie C-C in Fig. 9,
- Fig. 12: eine perspektivische, ausschnittsweise Darstellung eines Ausschnitts einer zweiten Ausführungsform des erfindungsgemäßen Läppstempels,
- Fig. 13: eine ausschnittsweise Seitenansicht des Läppstempels aus Fig. 12,
- Fig. 14: eine perspektivische, ausschnittsweise Darstellung einer dritten Ausführungsform des erfindungsgemäßen Läppstempels,
- Fig. 15: eine ausschnittsweise Seitenansicht des Läppstempels aus Fig. 14,
- Fig. 16: eine perspektivische, ausschnittsweise Darstellung einer vierten Ausführungsform des erfindungsgemäßen Läppstempels und
- Fig. 17: eine ausschnittsweise Seitenansicht des Läppstempels aus Fig. 16.

### Detaillierte Beschreibung der Erfindung

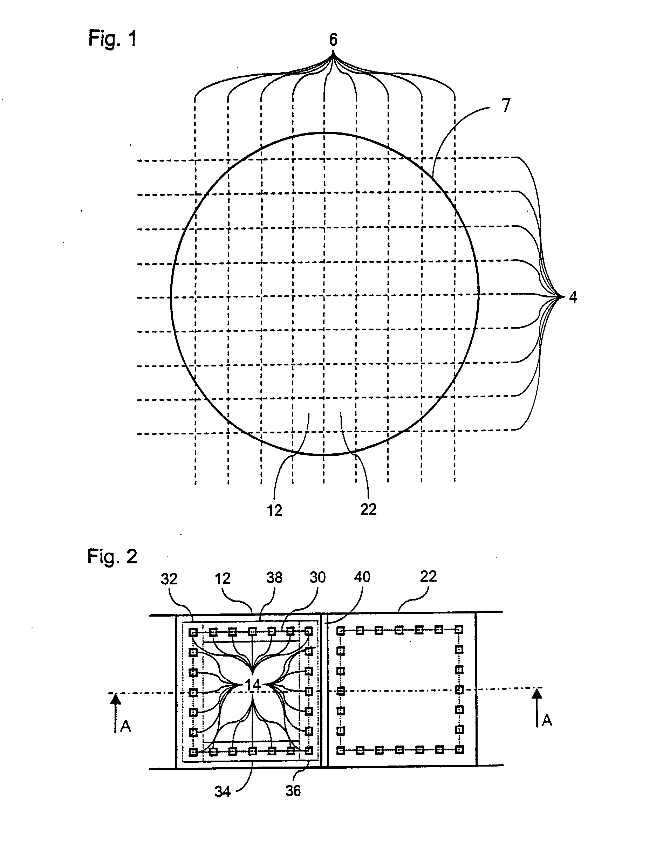

Fig. 1 zeigt einen Wafer 7, welcher zum Ende des Fertigungsprozesses entlang horizontaler und vertikaler Schnittlinien 4, 6 in eine Vielzahl von quadratischen Chips zerteilt wird. Das Zerteilen wird typischerweise als "Dicing" bezeichnet und ist als solches grundsätzlich bekannt.

Fig. 2 zeigt in einem Ausschnitt des Wafers aus Fig. 1 exemplarisch zwei gleiche Chips oder Halbleiterchips 12, 22. Der erste Chip 12 weist eine Vielzahl von im wesentlichen rechteckigen oder genauer quadratischen Öffnungen 14 auf. Die Öffnungen 14 sind entlang der Seiten oder Kanten eines inneren Quadrats 30 angeordnet, wobei die Öffnungen 14 in vier Gruppen 32, 34, 36, 38 erzeugt werden bzw. angeordnet sind, wobei jede der vier Gruppen eine längliche Struktur bildet. Die vier Gruppen 32, 34, 36, 38 von Öffnungen erstrecken sich jeweils linienförmig entlang einer geraden, parallel einer der Kanten des Quadrats 30 verlaufenden Linie.

Entlang einer Grenzlinie zwischen dem ersten Chip 12 und dem zweiten Chip 22 erstreckt sich ein länglicher, linienförmiger, gerader Graben 40, welcher ebenfalls eine längliche Struktur im Sinne der Erfindung ist.

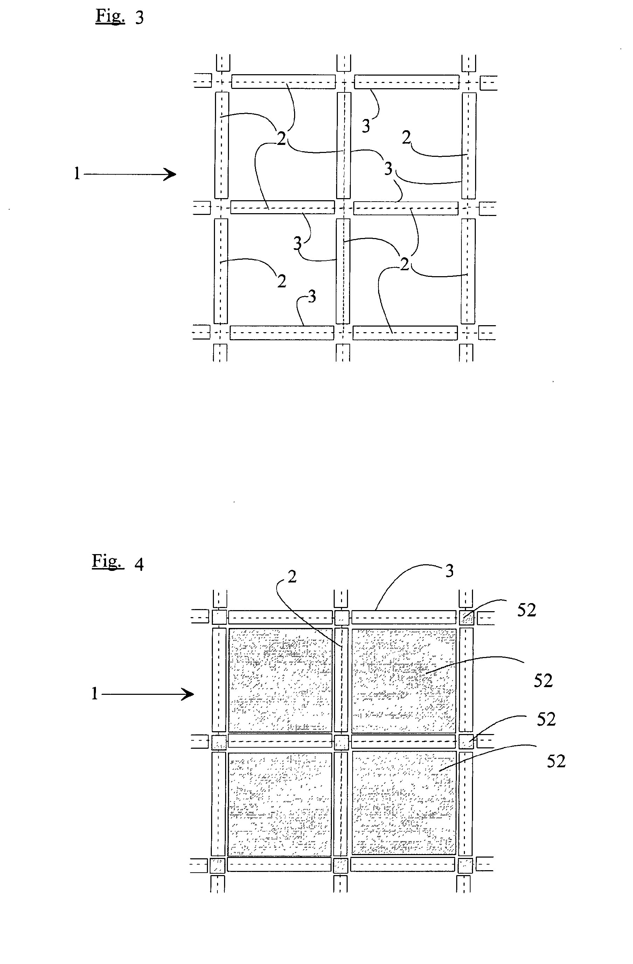

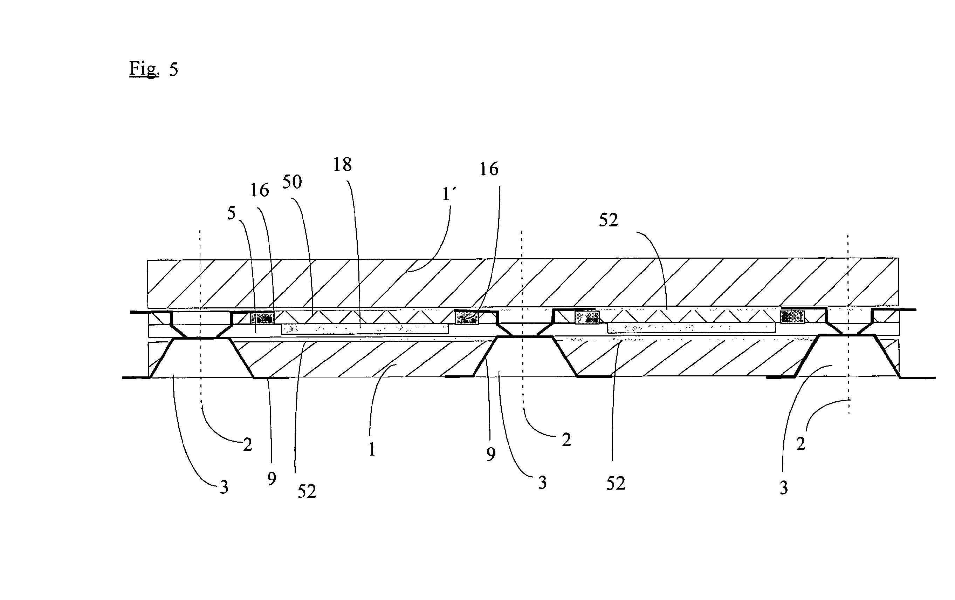

Unter Bezugnahme auf die Figuren, ist bei Fig. 3 schematisch ein Abdeckungsmaterial 1 dargestellt, welches beispielhaft aus einer Glasscheibe besteht. Das Abdeckungsmaterial 1 ist, wie bei Fig. 5 zu sehen zum rückseitigen Aufbringen auf ein Trägersubstrat 5 mit mehreren integrierten beispielsweise optischen Bauelementen (Chips), die mittels eines sogenannten "Waver-Level Package Verfahrens" hergestellt werden, entsprechend angepasst. Mit anderen Worten werden hierbei die Chips noch im Waferverband gehäust und die Kontakte nach außen geführt.

In Bezug auf die hierbei zugrunde zu legende mechanische Gehäusung und elektrische Kontaktierung von integrierten Schaltungen, d.h. insbesondere auf ein Durchkontaktieren durch das Trägersubstrat 5 wird auf die parallele, beim Deutschen Patent- und Markenamt vom gleichen Anmelder unter dem Titel "Verfahren zum Kontaktieren und Gehäusen von integrierten Schaltungen" verwiesen, deren Offenbarungsgehalt vollständig zum Offenbarungsgehalt der vorliegenden Beschreibung gehört.

Die gestrichelten Linien 2 gemäß den Figuren definieren hierbei die Zerlegungslinien für eine sich nach der Gehäusung und Kontaktierung anschließende Zerlegung des Waferverbands, d.h. die für das anschließende Dicing des Wafers in einzelne Chips, und definieren somit die anschließende Chipgröße.

Entlang der für die Trennung des Wafers zuordenbaren Zerlegungslinien werden gemäß Fig. 3 zunächst in dem Glas Schlitze 3 ausgebildet, so dass sich diese folglich an den Rändern der zu zerlegenden Chips befinden.

Für eine Verbindung von jeweiligen integrierten Bauelementen zugeordneten, wie zum Beispiel den mit der Bezugsziffer 16 gemäß Fig. 5 gekennzeichneten Kontaktbereichen hin zum Außenbereich des gehäusten Chips teilen sich folglich jeweils zwei benachbarte Chips einen Schlitz 3, über den die entsprechenden Kontaktverbindungen, wie nachfolgend beschrieben, geführt werden können.

Für die Strukturierung der Schlitze 3 wird in bevorzugter Weise zunächst eine nicht dargestellte Maske, beispielsweise mittels eines Siebdruckverfahrens und/oder photolithographischen Verfahrens aufgebracht. Eine hierbei erzeugte Bandstruktur von 100 bis 200 µm hat sich hierbei als ausreichend erwiesen. Das Erzeugen der Schlitze 3 selbst erfolgt in bevorzugter Weise mittels Sandstrahlung, wobei insbesondere ein dünnes Display-Glas, welches sich für vielfältige, einem Fachmann auf diesem Gebiet an sich bekannte Anwendungen als Abdeckungsmaterial besonders gut eignet, aufgrund einer hohen Abtragsrate infolge des abrasiven Prozesses sehr schnell bearbeitbar ist.

Es sei jedoch an dieser Stelle erwähnt, dass sich grundsätzlich auch andere Materialien, wie beispielsweise ein Kunststoff für eine derartige Strukturierung eignen, und ferner das Abdeckungsmaterial nicht zwingend transparent sein muss.

Beim vorliegenden Ausführungsbeispiel weisen die Schlitze 3 nach deren Strukturierung eine Breite von ca. 200 bis 500 µm auf und eine Länge, die, wie aus Fig. 3 zu sehen, etwas kürzer ist als die Längsseite eines Chips, so dass zwischen den Schlitzen einzelne Stege stehenbleiben. Die Länge eines Schlitzes ist im wesentlichen durch die Stabilitätsgrenze des als Abdeckung verwendeten Materials 1 begrenzt.

Die Strukturierung der Schlitze 3 mittels Sandstrahlung durchzuführen, führt zu einer trichterförmigen Mündung, wie beispielsweise bei Fig. 5 zu sehen, die für eine ggfs. anschließende photolithographische Bearbeitung des Abdeckungsmaterials 1 zur Herstellung einer aus dem Chip hinaus führenden Kontaktverbindung 9 von Vorteil ist.

Anstelle eines Sandstrahles kann das Ausbilden der Schlitze 3 auch mit anderen dafür geeigneten Verfahren, insbesondere mittels eines Ultraschallschwingläppens durchgeführt werden, welches zu einer höheren Genauigkeit der Schlitzdimensionierung führt. Für die Strukturierung durch Ultraschallschwingläppen eignen sich in besonders bevorzugter Weise die speziellen Verfahren und Vorrichtungen, wie sie in der parallelen beim Deutschen Patent- und Markenamt eingereichten Anmeldung des gleichen Anmelders mit dem Titel "Verfahren zur Erzeugung einer Struktur in einem Werkstück" beschrieben sind. Der Inhalt dieser in Bezug genommenen Anmeldung ist daher vollständig als Teil des vorliegenden Offenbarungsgehalts anzusehen.

Nach der Strukturierung des Abdeckungsmaterials 1 mit Schlitzen 3 wird auf diesem, wie bei Fig. 4 dargestellt, ein Haftmittel 52, vorzugsweise ein Epoxid, ein Wachs oder ein Sol Gel beispielsweise mittels Siebdruck aufgebracht. Eine weitere Möglichkeit besteht jedoch auch darin, das Abdeckungsmaterial 1 mittels Bonden, insbesondere anodisches Bonden auf den Wafer bzw. den Waferverband aufzubringen.

Da, wie vorstehend bereits erwähnt, bei vielen Anwendungen, insbesondere im Bereich des Electronic Packaging über die Schlitze Kontaktverbindungen zwischen an dem integrierten Bauelement vorgesehenen Kontaktbereichen und dem äußeren Gehäuse des integrierten Bauelements hergestellt werden müssen, ist bevorzugt vorgesehen, die Schlitze 3 von Haftmitteln 52 frei zu halten.

Bei dem in Fig. 5 dargestellten schematischen Querschnitt durch einen Teil eines Waferverbands, ist das vorstehend beschriebene erfindungsgemäß mit Schlitzen 3 strukturierte Trägersubstrat 1 rückseitig an dem Waferverband aufgebracht.

Der dargestellte Waferverband umfasst hierbei je Chip eine Siliziumschicht 5 als Trägersubstrat, welches zur einen Oberfläche hin eine optisch aktive Schicht 18, wie etwa die Sensorschicht eines CCD-Chips umfasst. Ferner ist das Siliziumsubstrat 5 mit einer Passivierungsschicht 50 bedeckt und Kontaktierungsbereiche oder sogenannte Bondpads 16 zum elektrischen Anschluss des jeweiligen Chips sind über nicht dargestellte Leiterbahnen mit der optisch sensitiven Schicht 18 verbunden.

Eine transparente Glasscheibe 1' ist zum Schutz der optisch sensitiven Schicht 18 zusätzlich auf die Oberseite des Waferverbandes mittels eines Haftmittels 52 aufgebracht. Auf der Rückseite, d.h. im vorliegenden Ausführungsbeispiel auf der optisch nicht aktiven Seite des Waferverbandes, ist die erfindungsgemäß strukturierte Abdeckung 1 ebenfalls mit Haftmitteln 52 befestigt.

Neben dem Schutz der Halbleiterschaltkreise an der optisch aktiven Oberseite hat die vorder- und/oder rückseitige Aufbringung einer Abdeckung ferner die Funktion, den gesamten Aufbau mechanisch zu stabilisieren.

Die Bondpads 16 sind über Kontaktverbindungen 9 zunächst durch Verbindungskanäle durch das Trägersubstrat 5 und anschließend über die Schlitze 3 zur rückseitigen Außenseite des Waferverbandes geführt. Das Ausbilden der Kontaktverbindungen durch die Schlitze 3, wird wie vorstehend erwähnt bevorzugt photolithographisch und/oder mittels einer Schichtabscheidung hergestellt.

Im Gegensatz zu bisher üblichen Verfahren kann in Folge der vorherigen Strukturierung des Abdeckungsmaterials 1 auf ein V-Grooving, d.h. das anschließende Einbringen von Gräben in dem auf das Trägersubstrat 5 aufgebrachte Abdeckungsmaterial verzichtet werden.

Wird der wie bei Fig. 5 dargestellte Waferverband anschließend in einzelne Chips getrennt, müssen darüber hinaus die Schlitze 3 des Abdeckungsmaterials 1 nicht mehr gesägt werden, sondern lediglich die zwischen den Schlitzen stehengelassenen Stege.

Darüber hinaus sieht die Erfindung vor, die Schlitze 3 ggfs. nach Ausbildung der Kontaktverbindungen 9, sei es durch Durchkontaktierungen gemäß vorstehend in Bezug genommener Patentanmeldung oder mittels eines anderen der an sich dem Fachmann auf diesem Gebiet bekannten Verfahren zum Wafer Level Packaging mit einem isolierenden Füllmaterial aufzufüllen, beispielsweise mit einem Epoxid um ein quasi-hermetisches Package herzustellen.

Es sei ferner darauf hingewiesen, dass je nach Anwendung bzw. Einsatz und/oder Weiterverarbeitung des Waferverbandes bzw. der einzelnen Chips im zerlegten oder unzerlegten Zustand auch die Abdeckung 1' auf der optisch aktiven Seite gemäß Fig. 5 zuvor mit entsprechenden Schlitzen strukturierbar ist. Ferner müssen die Materialien zur vorder- und rückseitigen Abdeckung 1' bzw. 1 nicht identisch sein. Um bei einer Erwärmung und/oder Abkühlung des Chips einen Di-Metalleffekt auszugleichen, ist es bereits ausreichend, dass sich die Steifigkeit der Materialien, insbesondere basierend auf deren Dicke, dem jeweiligen E-Modul und den Wärmeausdehnungskoeffizienten gegenseitig kompensieren, um ein Verbiegen des Chips zu vermeiden.

Ein derart montiertes Trägersubstrat 5 mit einem oder mehreren integrierten Bauelementen eignet sich ferner zur Herstellung von dreidimensional aufgebauten integrierten Schaltungen, insbesondere gemäß dem Offenbarungsinhalt der gleichermaßen parallel beim Deutschen Patent- und Markenamt anhängigen Anmeldung des gleichen Anmelders unter dem Titel "Verfahren zur Herstellung von dreidimensional aufgebauten integrierten Schaltungen und mehrschichtige Halbleitervorrichtung" deren Inhalt somit voll umfänglich zum Offenbarungsinhalt der vorliegenden Beschreibung gehörend anzusehen ist.

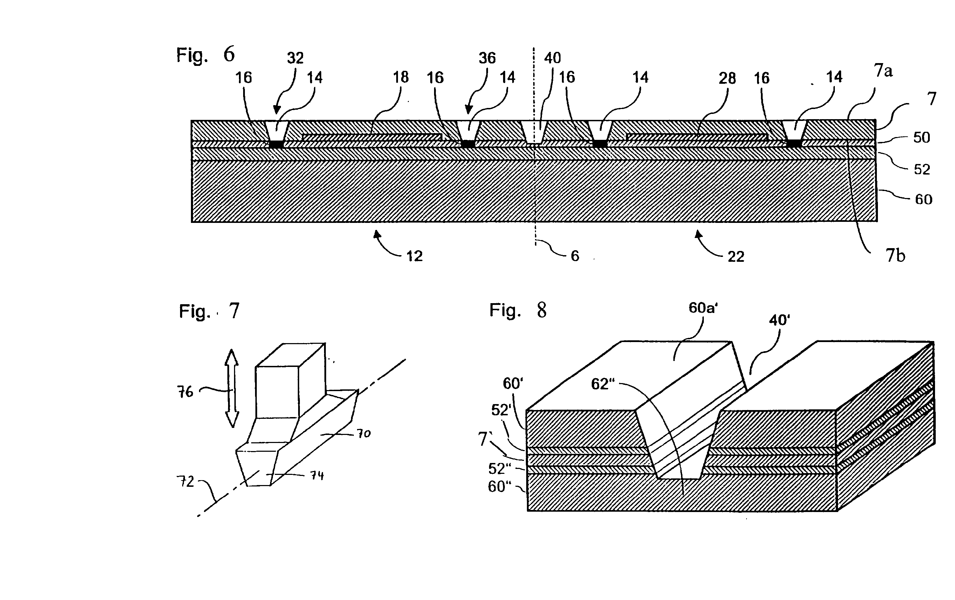

Fig. 6 zeigt in einer Schnittzeichnung durch die beiden in Fig. 2 dargestellten noch im ungeteilten Waferverbund befindlichen Chips 12, 22. Der Wafer 7 weist an seiner Unterseite eine Passivations- oder Passivierungsschicht 50 auf und ist mit einer Epoxidharzschicht 52 auf einen Glasträger 60 aufgeklebt. Auf der Unterseite des Wafers 7 innerhalb der Passivationsschicht 50 befinden sich Kontaktstellen oder Bondpads 16. Die Bondpads 16 sind mittels Läppen über die Öffnungen 14 durch den Wafer hindurch freigelegt und von oben kontaktierbar. Ferner weisen der erste und zweite optische Chip 12, 22 je einen lichtsensitiven Bereich, z.B. einen CCD 18 bzw. 28 auf.

In der Herstellung wird zunächst der mit den Bondpads 16 und den lichtempfindlichen Bereichen 18, 28 versehene Wafer 7 mittels des Epoxidharzes 52 mit dem Glasträger 60 verklebt. Danach werden mittels des erfindungsgemäßen Läppverfahrens mit einem Läppstempel sukzessive oder zumindest teilweise gleichzeitig der Graben 40, die erste, zweite, dritte und vierte linienförmige Gruppe 32, 34, 36, 38 von Öffnungen 14 in den Wafer 2 eingeläppt.

Wie in Fig. 6 zu sehen ist, weisen sowohl die Öffnungen 14, zumindest in einer Dimension, als auch der Graben 40 einen sich nach unten verjüngenden trapezförmigen Querschnitt auf. Die Öffnungen 14 erstrecken sich von einer ersten Oberfläche 7a des Wafers 7 bis zu den zugehörigen Bondpads 16 an einer zweiten Oberfläche 7b des Wafers 7. Der Graben 40 erstreckt sich von der ersten Oberfläche 7a bis in die Passivierungsschicht 50.

Fig. 7 zeigt eine erste Ausführungsform eines erfindungsgemäßen Stempels oder Läppstempels 70 mit einer Längsachse 72. Der Läppstempel 70 weist senkrecht zu der Längsachse 72 einen trapezförmigen Querschnitt 74 auf und schwingt linear entlang des Pfeils 76.

Weiter zeigt Fig. 8 eine alternative Ausführungsform eines Wafers 7', welcher beidseitig mittels Epoxidschichten 52', 52'' mit einem ersten und zweiten Glasträger 60', 60'' zu einem sandwichartigen Verbund beidseitig verklebt ist. Ein Graben oder V-Groove 40', welcher mittels des Läppstempels 70 erzeugt wird, erstreckt sich von einer ersten Oberfläche 60a' des ersten Glasträgers 60' vollständig durch den ersten Glasträger 60', die erste Epoxidschicht 52', den Siliziumwafer 7' und die zweite Epoxidschicht 52'', so dass innerhalb des Grabens 40' der Siliziumwafer 7' über seine gesamte Dicke freiliegt. Hiernach kann sich ein Verfüllen des Grabens 40' mit isolierendem Material zur Versiegelung der Waferstirnseiten oder ein stirnseitiges Kontaktieren des Wafers 7' innerhalb des Grabens 40' anschließen. Danach wird mit einem Läppstempel, welcher schmaler als der Läppstempel 70 ist, ein verbleibender Verbindungssteg 62'' des unteren Glasträgers 60'' durchtrennt, um einzelne, insbesondere allseitig versiegelte Chips zu erhalten.

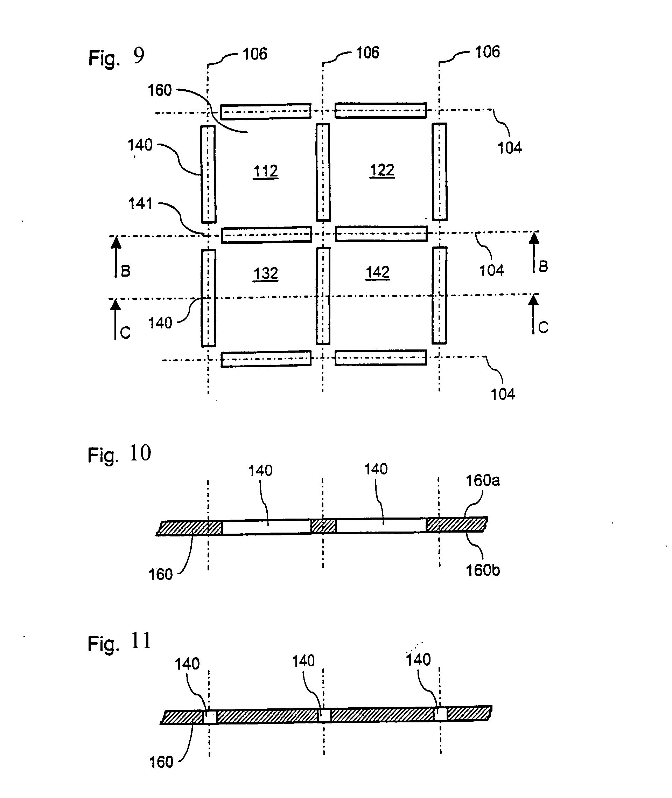

Fig. 9 zeigt eine alternative Verwendungsmöglichkeit des erfindungsgemäßen Läppverfahrens an einem Glasträger 160, welcher noch nicht mit einem Wafer verbunden ist. Der in Fig. 9 dargestellte Ausschnitt des Glasträgers 160 unterteilt sich in vier Abschnitte 112, 122, 132 und 142, welche von Begrenzungskanten 104, 106 horizontal bzw. vertikal voneinander abgegrenzt und einzelnen Chips auf einem Wafer zugeordnet sind. Entlang der Begrenzungskanten 104, 106 der vier quadratischen Bereiche 112, 122, 132, 142 werden jeweils länglich rechteckige Öffnungen 140 eingebracht oder eingeläppt. Zwischen aneinander anschließenden Öffnungen 140 wird jeweils ein Steg 141 stehengelassen, so dass der Glasträger 160 als ein Stück bestehen bleibt. Die Begrenzungskanten 104, 106 bilden jeweils die Längsachsen einer sich linienförmig erstreckenden Struktur, umfassend eine oder mehrere der Öffnungen 140.

Fig. 10 zeigt zwei der Öffnungen 140 in einer Schnittzeichnung entlang der Linie B-B in Fig. 9, d.h. entlang der Längsachse der Öffnungen 140. Die Öffnungen 140 durchdringen den Glasträger 160 vollständig von einer ersten Oberfläche 160a bis zu einer zweiten Oberfläche 160b.

Fig. 11 zeigt drei Öffnungen 140 in einem Schnitt entlang der Linie C-C in Fig. 9, d.h. quer oder senkrecht zur Längsachse der Öffnungen 140. Die Öffnungen 140 haben gemäß diesem Ausführungsbeispiel quer zu ihrer Längsachse einen quadratischen Querschnitt, können aber in anderen Ausführungsformen auch z.B. einen trapez- oder dreiecksförmigen Querschnitt aufweisen. Nach dem Einbringen der Öffnungen 140 in den Glasträger 160 wird dieser genau positioniert auf einem Wafer aufgeklebt, so dass die Begrenzungslinien 104, 106 auf den späteren Schnittkanten der Chips, wie z.B. in Fig. 1 zu sehen ist, zu liegen kommen. Dadurch entsteht eine Anordnung ähnlich wie die in Fig. 6 gezeigte. Hierbei sind durch die Öffnungen 140 der Wafer, insbesondere auf dem Wafer angeordnete Bondpads freiliegend erreichbar.

Die Figuren 9 bis 11 sind ferner aus Gründen der besseren Darstellung nicht maßstabsgetreu. Die Länge der Öffnungen 140 beträgt etwa 1 mm bis 40 mm und die Breite etwa 40 µm bis 100 µm, 100 µm bis 100 µm oder 300 µm bis 800 µm.

Der Glasträger 160 umfasst z.B. alkalifreies Glas, insbesondere AF45 oder Glas der Sorte D263 der Firma Schott Glas, welche einen Ausdehnungskoeffizienten von etwa 4,5 x 10⁻⁶ aufweisen, welcher ähnlich dem des Siliziums mit 3,6 x 10⁻⁶ ist.

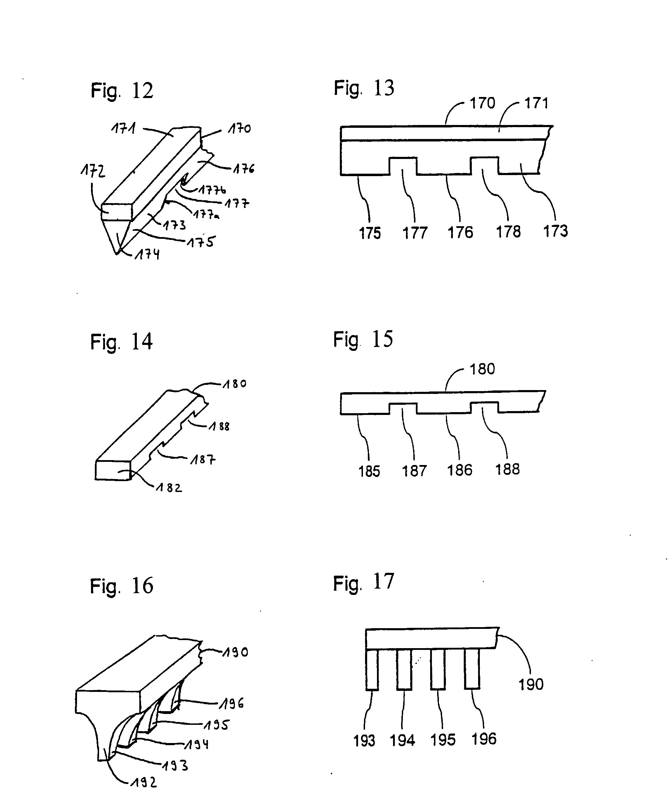

Fig. 12 zeigt eine zweite Ausführungsform des erfindungsgemäßen Läppstempels 170 mit einem Kopfabschnitt 171 mit einem rechteckigen Querschnitt 172 und einem unteren Abschnitt 173 mit einem dreieckigen Querschnitt 174. Der untere Abschnitt 173 weist materialabtragende Abschnitte 175, 176 und eine dazwischen angeordnete Aussparung 177 auf. Zwei Stirnflächen 177a, 177b der rechteckigen Aussparung 177 erstrecken sich parallel zueinander und senkrecht zur Längsachse des Läppstempels. Mit dem Läppstempel 170 wird ein geschlitztes Werkstück mit schrägen Seitenflächen erzeugt.

Fig. 13 zeigt den Läppstempel aus Fig. 12 in einer Seitenansicht, wobei noch eine zweite Aussparung 178 dargestellt ist.

Fig. 14 zeigt eine dritte Ausführungsform des erfindungsgemäßen Läppstempels 180 mit rechteckigem Querschnitt 182 und Aussparungen 187, 188. Mit dem Läppstempel 180 wird ein geschlitztes Werkstück, z.B. der geschlitzte Glasträger 160 in Fig. 9 mit Schlitz-Seitenflächen, welche im wesentlichen senkrecht zur Oberfläche verlaufen, erzeugt.

Fig. 15 zeigt eine Seitenansicht des Läppstempels 180.

Fig. 16 zeigt eine vierte Ausführungsform des Läppstempels 190 zur Erzeugung einer linienförmigen oder länglichen Struktur umfassend eine Mehrzahl von entlang einer geraden Linie angeordneten Löchern.

Der Läppstempel 190 umfasst eine Mehrzahl von sich verjüngenden materialabtragenden Abschnitten 193, 194, 195, 196 mit jeweils konkaven Seitenflächen und sich nach unten verjüngendem Querschnitt 192. Mit dem Läppstempel 190 ist z.B. in einem Arbeitsgang je eine der Gruppen 32, 34, 36, 38 von Öffnungen 14, wie in Fig. 2 dargestellt, herstellbar.

Die Erzeugung der Öffnungen 14 erfolgt insbesondere gruppenweise und/oder chipweise, so dass pro Chip vier Läppvorgänge durchgeführt werden. Es ist aber auch möglich, die Erzeugung der Öffnungen 14 waferweise durchzuführen, so dass mehrere entlang einer geraden Linie auf dem Wafer angeordnete Chips gleichzeitig mit Öffnungen versehen werden.

Fig. 17 zeigt eine Seitenansicht des Läppstempels 190.

In einer besonders vorteilhaften Weiterbildung der Erfindung werden mehrere der Läppstempel nebeneinander angeordnet, so dass sogar mehrere Reihen von Öffnungen oder ein zweidimensionales Array von Öffnungen gleichzeitig erzeugbar sind. Gemäß einer besonders bevorzugten Ausführungsform werden in einem Arbeitsschritt alle Öffnungen 14 auf dem gesamten Wafer 7 gleichzeitig erzeugt.

Alternativ zu den gezeigten Ausführungsformen kann das Läppwerkzeug eine Platte mit einem zweidimensionalen Array aus nadelartigen Spitzen oder Stempeln umfassen, so dass ebenfalls ein zweidimensionales Array von Öffnungen gleichzeitig erzeugbar ist.

Es ist dem Fachmann ersichtlich, dass die Erfindung nicht auf die vorstehend beschriebenen Ausführungsformen beschränkt ist, sondern vielfältig, insbesondere in Bezug auf die Form des Läppstempels und der damit erzeugbaren Struktur variiert werden kann, ohne den Geist der Erfindung zu verlassen.

## Patentansprüche

1. Verfahren zur Strukturierung eines Abdeckungsmaterials (1) zum Aufbringen auf ein Trägersubstrat (5) mit wenigstens einem integrierten Bauelement, mit folgenden Schritten:
Bereitstellen einer im Wesentlichen ebenen Platte als Abdeckungsmaterial (1), und
Ausbilden von Schlitzen (3) am Abdeckungsmaterial derart, dass Schlitze (3) im aufgebrachten Zustand im Wesentlichen entlang für eine Zerlegung des Trägersubstrats (5) in wenigstens einen, wenigstens ein integriertes Bauelement umfassenden Chip entsprechend zuordenbaren Zerlegungslinien (2) angeordnet sind.

2. Verfahren nach Anspruch 1, **dadurch gekennzeichnet, dass** das Abdeckungsmaterial (1) aus einem transparenten Material bereitgestellt wird.

3. Verfahren nach Anspruch 1 oder 2, **dadurch gekennzeichnet, dass** das Abdeckungsmaterial (1) aus Glas, insbesondere aus beschichtetem oder strukturiertem Glas bereitgestellt wird.

4. Verfahren nach einem der Ansprüche 1 oder 2, **dadurch gekennzeichnet, dass** das Abdeckungsmaterial (1) aus einem Kunststoff bereitgestellt wird.

5. Verfahren nach einem der Ansprüche 1 bis 4, **dadurch gekennzeichnet, dass** die Schlitze (3) mit einer Schlitzbreite von 200µm bis 500µm und mit einer gegenüber den jeweiligen Längen der entsprechenden Zerlegungslinien (2) kürzeren Schlitzlänge ausgebildet werden.

6. Verfahren nach einem der vorstehenden Ansprüche, **dadurch gekennzeichnet, dass** zum Ausbilden der Schlitze (3) an dem Abdeckungsmaterial (1) eine entsprechend vorstrukturierte Maske auf das Abdeckungsmaterial (1) aufgebracht wird.

7. Verfahren nach einem der vorstehenden Ansprüche, **dadurch gekennzeichnet, dass** das Ausbilden der Schlitze (3) mittels Sandstrahlen erfolgt.

8. Verfahren nach einem der Ansprüche 1 bis 6, **dadurch gekennzeichnet, dass** das Ausbilden der Schlitze (3) mittels Ultraschallschwingläppen erfolgt.

9. Verfahren nach Anspruch 8 zum Erzeugen einer Struktur (32, 40, 40', 140) in einem Werkstück mit einer ersten Oberfläche (7a, 160a), das Verfahren umfassend Bereitstellen des Werkstücks (7, 160),
Bereitstellen eines Werkzeuges
Bereitstellen eines Abrasivmittels
Läppen, insbesondere Ultraschallschwingläppen, des Werkstücks (7, 160) mittels des Werkzeuges und des Abrasivmittels,
wobei das Werkzeug einen Läppstempel (70, 170, 180, 190) umfasst, welcher sich zumindest in einer ersten Dimension entlang der ersten Oberfläche (7a, 160a) des Werkstücks erstreckt und mit welchem vermittels des Läppens eine sich zumindest entlang der ersten Dimension erstreckende Struktur (32, 40, 40', 140) in dem Werkstück erzeugt wird.

10. Verfahren gemäß Anspruch 9, wobei sich die erste Oberfläche (160) in einer ersten Ebene erstreckt und die Struktur einen Schlitz (40, 40', 140), insbesondere einen länglichen und/oder linienförmigen Schlitz (40, 40', 140), welcher sich im wesentlichen parallel zu der ersten Ebene erstreckt, umfasst.

11. Verfahren gemäß Anspruch 91 oder 10, wobei ein einstückiger Läppstempel (70, 170, 180, 190) verwendet wird.

12. Verfahren gemäß einem der vorstehenden Ansprüche, wobei ein formgebender Läppstempel (70, 170, 180, 190) verwendet wird.

13. Verfahren gemäß einem der vorstehenden Ansprüche, wobei der Läppstempel (70, 170, 180, 190) entlang der ersten Dimension länglich ausgedehnt ist und in einer Ebene senkrecht zu der ersten Dimension zumindest abschnittsweise einen Querschnitt (74, 174, 182, 192) aufweist, welcher im wesentlichen der Negativform des Querschnitts der zu erzeugenden Struktur (32, 40, 40', 140) entspricht.

14. Verfahren gemäß einem der vorstehenden Ansprüche, wobei der Läppstempel (70, 170, 180, 190) entlang der ersten Dimension länglich ausgedehnt ist und in einer Ebene senkrecht zu der ersten Dimension zumindest abschnittsweise einen Querschnitt aufweist, welcher in Richtung zum Werkstück verjüngend (74, 174, 192), dreieckig (174), trapezförmig (74) oder rechteckig (182) ausgebildet ist.

15. Verfahren gemäß einem der vorstehenden Ansprüche, wobei der Läppstempel Aussparungen (177, 178, 187, 188) und materialabtragende Abschnitte (175, 176, 185, 186), insbesondere sich regelmäßig abwechselnd, aufweist, wobei mit den materialabtragenden Abschnitten (175, 176, 185, 186) gleichzeitig eine Mehrzahl von Vertiefungen (40, 40') und/oder Öffnungen (14, 140) in dem Werkstück erzeugt werden.

16. Verfahren gemäß einem der vorstehenden Ansprüche, wobei mittels des Läppens eine Mehrzahl (32, 34, 36, 38) von entlang einer Linie fluchtenden Vertiefungen (40, 40') und/oder Öffnungen (14, 140) erzeugt werden, welche insbesondere entlang der Linie fluchtende linienförmige Vertiefungen (40, 40') oder Öffnungen (140) umfassen.

17. Verfahren gemäß einem der vorstehenden Ansprüche, wobei das Werkstück einen Halbleiter- oder Siliziumwafer (7) umfasst.

18. Verfahren gemäß einem der vorstehenden Ansprüche, wobei das Werkstück einen Materialverbund, insbesondere einen Glas-Siliziumwafer-Verbund umfasst.

19. Verfahren gemäß einem der vorstehenden Ansprüche, wobei das Werkstück, insbesondere der Wafer (7) oder Glas-Siliziumwafer-Verbund Kontaktstellen (16) auf einer zweiten Oberfläche (7b), welche gegenüber der ersten Oberfläche (7a) angeordnet ist, aufweist und mittels des Läppens zumindest eine Öffnung (14) erzeugt wird, welche sich von der ersten zur zweiten Oberfläche (7a, 7b) durch das Werkstück, den Wafer (7) bzw. den Glas-Siliziumwafer-Verbund hindurch erstreckt, wobei die Kontaktstellen (16) freigelegt werden und von der ersten Oberfläche (7a) aus kontaktierbar sind.

20. Verfahren gemäß einem der vorstehenden Ansprüche, wobei mittels des Läppens in dem Werkstück, insbesondere in dem Wafer (7) oder Glas-Siliziumwafer-Verbund Gräben (40, 40') erzeugt werden.

21. Verfahren gemäß einem der vorstehenden Ansprüche, wobei mittels des Läppens sich verjüngende Gräben (40, 40'), insbesondere V-Gräben in dem Werkstück, insbesondere in dem Wafer (7) oder Glas-Siliziumwafer-Verbund erzeugt werden.

22. Verfahren gemäß einem der vorstehenden Ansprüche, wobei mittels des Läppens das Werkstück, insbesondere der Wafer (7) oder Glas-Siliziumwafer-Verbund in Chips (12, 22) zerteilt oder zerschnitten wird.

23. Verfahren gemäß einem der vorstehenden Ansprüche, wobei die Struktur (32, 40, 40', 140) in dem Werkstück mit einer arithmetischen Rauheit von kleiner als 10 µm, bevorzugt kleiner als 5 µm, besonders bevorzugt im Bereich von 1 µm bis 2 µm erzeugt wird.

24. Verwendung des Verfahrens gemäß einem der vorstehenden Verfahrensansprüche für die Bearbeitung eines Glas-Siliziumwafer-Verbunds.

25. Verwendung des Verfahrens gemäß einem der vorstehenden Verfahrensansprüche zum Zerteilen oder Zerschneiden eines Wafers (7), insbesondere umfasst um einen Glas-Siliziumwafer-Verbund.

26. Verwendung des Verfahrens gemäß einem der vorstehenden Verfahrensansprüche zum Erzeugen von V-Gräben (40, 40') in einem Wafer (7), insbesondere in einem Glas-Siliziumwafer-Verbund.

27. Verfahren zur Montage von wenigstens einem, in einem Trägersubstrat (5) integrierten Bauelement, mit folgenden Schritten:
Strukturieren eines Abdeckungsmaterials (1) nach dem Verfahren gemäß eines der vorstehenden Ansprüche,
Beschichten des strukturierten Abdeckungsmaterials (1) mit einem Haftmittel (52), und
Aufbringen des beschichteten Abdeckungsmaterials (1) an einer Oberfläche des Trägersubstrats (5).

28. Verfahren nach Anspruch 27, **dadurch gekennzeichnet, dass** das Abdeckungsmaterial (1) auf die Vorderseite oder Rückseite des Trägersubstrats (5) aufgebracht wird.

29. Verfahren nach einem der Ansprüche 27 bis 28, **dadurch gekennzeichnet, dass** das Abdeckungsmaterial (1) auf einem optisch aktiven und/oder passiven Oberflächenbereich am Trägersubstrat (5) aufgebracht wird.

30. Verfahren nach einem der Ansprüche 27 bis 29, **dadurch gekennzeichnet, dass** das Beschichten mit Haftmitteln (52) mittels eines Siebdruckverfahrens erfolgt.

31. Verfahren nach einem der Ansprüche 27 bis 30, **dadurch gekennzeichnet, dass** als Haftmittel (52) ein Epoxidharz, ein Wachs und/oder ein Sol Gel verwendet wird.

32. Verfahren nach einem der Ansprüche 27 bis 29, **dadurch gekennzeichnet, dass** das Abdeckungsmaterial (1) durch anodisches Bonden auf das Trägersubstrat aufgebracht wird.

33. Verfahren nach einem der Ansprüche 27 bis 32, **dadurch gekennzeichnet, dass** nach Aufbringen des Abdeckungsmaterials (1) wenigstens eine durch einen Schlitz (3) hindurch führende Kontaktverbindung (9) zu einer dem wenigstens einen Bauelement zugeordneten Kontaktierungseinrichtung (16) ausgebildet wird.

34. Verfahren nach Anspruch 33, **dadurch gekennzeichnet, dass** das Ausbilden der Kontaktverbindung (9) photolitographisch durchgeführt wird.

35. Verfahren nach Anspruch 33, **dadurch gekennzeichnet, dass** das Ausbilden der Kontaktverbindung (9) mittels eines Abscheidungsprozesses durchgeführt wird.

36. Verfahren nach einem der Ansprüche 27 bis 36, **dadurch gekennzeichnet, dass** Schlitze (3) zum Ausbildung von Kontaktverbindungen (9) wenigstens teilweise mit einem leitfähigen Füllmaterial aufgefüllt werden.

37. Verfahren nach einem der Ansprüche 27 bis 36, **dadurch gekennzeichnet, dass** Schlitze (3) wenigstens teilweise mit einem leitfähigen und/oder isolierenden Füllmaterial aufgefüllt werden.

38. Verfahren nach einem der Ansprüche 27 bis 37, **dadurch gekennzeichnet, dass** das Trägersubstrat (5) einschließlich des Abdeckungsmaterials (1) entlang daran ausgebildeter Schlitze (3) in wenigstens einen, wenigstens ein integriertes Bauelement umfassenden Chip zerlegt wird.

39. Wafer (7) oder Glas-Siliziumwafer-Verbund oder ein daraus herstellbarer Chip (12, 22) mit einer Struktur (32, 40, 40', 140) erzeugbar nach einem Verfahren gemäß einem der vorstehenden Ansprüche.

40. Vorrichtung zum Abdecken von wenigstens einem, auf einem Trägersubstrat (5) integrierten Bauelement, wobei die Vorrichtung eine im Wesentlichen ebene Platte oder Scheibe (1) umfasst, **dadurch gekennzeichnet, dass** die Platte Aussparungen in Form von Schlitzen (3) beinhaltet.

41. Vorrichtung nach Anspruch 40, **dadurch gekennzeichnet, dass** Schlitze (3) im Wesentlichen entlang für eine Zerlegung des Trägersubstrats (5) in wenigstens einen, wenigstens ein integriertes Bauelement umfassenden Chip entsprechend zuordenbaren Zerlegungslinien angeordnet sind.

42. Vorrichtung nach Anspruch 40 oder 41, **dadurch gekennzeichnet, dass** die Platte (1) transparent ist.

43. Vorrichtung nach Anspruch 40, 41 oder 42, **dadurch gekennzeichnet, dass** die Platte (1) Glas, insbesondere beschichtetes oder strukturiertes Glas umfasst.

44. Vorrichtung nach Anspruch 401, 41 oder 42, **dadurch gekennzeichnet, dass** die Platte (1) einen Kunststoff umfasst.

45. Vorrichtung nach einem der Ansprüche 40 bis 44, **dadurch gekennzeichnet, dass** die Platte (1) zur Vorderseitigen oder Rückseitigen Abdeckung des wenigstens einen Bauelements entsprechend ausgebildet ist.

46. Vorrichtung mit wenigstens einem auf einem Trägersubstrat (5) integrierten Bauelement, umfassend eine mit Schlitzen (3) strukturierte Abdeckung nach einem der Ansprüche 40 bis 45.

47. Vorrichtung nach Anspruch 46, **gekennzeichnet durch** wenigstens ein wenigstens einseitig optisch aktives Bauelement.

48. Vorrichtung nach Anspruch 46 oder 47, **dadurch gekennzeichnet, dass** die Abdeckung (1) an einem passiven Oberflächenbereich des Trägersubstrats (5) aufgebracht ist.

49. Vorrichtung nach einem der Ansprüche 46 bis 48, **dadurch gekennzeichnet, dass** durch an der Abdeckung (1) ausgebildete Schlitze (3) Kontaktverbindungen (9) zu einer dem wenigstens einen Bauelement zugeordneten Kontaktierungseinrichtung (9) ausgebildet sind.

50. Vorrichtung nach einem der Ansprüche 46 bis 49, **dadurch gekennzeichnet, dass** an der Abdeckung (1) ausgebildete Schlitze (3) wenigstens teilweise mit einem leitfähigen oder nicht-leitfähigem Füllmaterial angereichert sind.

51. Vorrichtung nach einem der Ansprüche 46 bis 50, **dadurch gekennzeichnet, dass** das wenigstens eine in dem Trägersubstrat (5) integrierte Bauelement durch Trennung eines Waferverbandes entlang von an der Abdeckung (1) strukturierten Schlitzen (3) hergestellt ist.

52. Läppstempel (70, 170, 180, 190), welcher sich zumindest in einer ersten Dimension entlang einer Oberfläche (7a, 160a) eines zu bearbeitenden Werkstücks (7) erstreckt und wobei mit dem Läppstempel (70, 170, 180, 190) vermittels eines Läppverfahrens, insbesondere gemäß einem der vorstehenden Ansprüche eine sich zumindest entlang der ersten Dimension erstreckende Struktur (32, 40, 40', 140) in dem Werkstück (7) erzeugbar ist.

53. Läppvorrichtung insbesondere zum Strukturieren, Zerteilen und/oder Zerschneiden von Wafern (7) oder Glas-Silizium-Verbund-Wafern, umfassend
eine Aufnahme für den Wafer (7) bzw. Glas-Silizium-Verbund-Wafer,
den Läppstempel (70, 170, 180, 190) gemäß Anspruch 52 und
eine Einrichtung zur Erzeugung von Schwingungen und zur Beaufschlagung des Läppstempels (70, 170, 180, 190) mit den Schwingungen.
